# EUROPÄISCHE PATENTANMELDUNG

(11) **EP 2 975 916 A1**
(43) Veröffentlichungstag der Anmeldung: **20.01.2016**
(21) Anmeldenummer: 15172854.0
(22) Anmeldetag: 19.06.2015
(51) Int. Cl.: H05K 1/05, H05K 1/18, H05K 3/38

(54) **LAMINAT ZUR HERSTELLUNG EINER IMS-LEITERPLATTE UND IMS-LEITERPLATTE**

(30) Priorität: 14.07.2014 DE 102014010329
(71) Anmelder: Carl Freudenberg KG, 69469 Weinheim (DE)
(72) Erfinder: Johann, Rudolf, 66539 Neunkirchen (DE); Neumann, Ludwig, 14542 Werder (DE); Farmer, Graham, Herefordshire, HR96BG (GB)

(57) **Zusammenfassung**

Ein flexibles Laminat zur dreidimensionalen Ausformung, umfassend mindestens drei Lagen (1, 1', 2, 3), wobei eine erste Lage (1, 1') und eine dritte Lage (3) aus Metall gefertigt sind, wobei die erste Lage (1, 1') und die dritte Lage (3) eine zweite Lage (2), welche als dielektrische Lage mit einer thermischen Leitfähigkeit ausgestaltet ist, zwischen sich aufnehmen, und wobei die zweite Lage (2) als Klebstoff ausgebildet ist, an welcher die erste Lage (1, 1') und die dritte Lage (3) jeweils stoffschlüssig angebunden sind, ist im Hinblick auf die Aufgabe, eine Leiterplatte derart auszugestalten und weiter zu bilden, dass diese bei möglichst guter thermischer Leitfähigkeit eine hohe Flexibilität zeigt, dadurch gekennzeichnet, dass das Laminat eine Gesamtdicke zwischen 45 und 440 µm, bevorzugt zwischen 100 µm und 250 µm, aufweist.

## Beschreibung

### Technisches Gebiet

Die Erfindung betrifft ein Laminat nach dem Oberbegriff des Patentanspruchs 1.

### Stand der Technik

Aus der JP 2007 110 010 A ist eine Leiterplatte mit einem Dielektrikum bekannt, welches als Kleber aus Epoxidharz ausgestaltet ist. Ein solches Dielektrikum weist eine relativ geringe thermische Leitfähigkeit auf. Die Leiterplatte weist eine untere Metallschicht auf, welche mechanisch angebunden ist.

Vor diesem Hintergrund sind bereits relativ starre IMS-Leiterplatten bekannt. IMS steht für "insulated metallic substrate". Unter IMS versteht der Fachmann ein Material für Leiterplatten, welches eine optimierte Wärmeableitung bewirkt, wie sie beispielsweise für Hochleistungselektroniken und Power LEDs erforderlich ist.

Typischerweise wird auf eine Lage aus Aluminium, welche meist 1 mm dick oder dicker ist, ein gut wärmeleitendes Dielektrikum aufgetragen und dieses mit einer Lage aus Kupfer abgedeckt. Die Lage aus Kupfer wird dann zur Herstellung einer IMS-Leiterplatte strukturiert.

Das verwendete Dielektrikum ist oft recht spröde und die Lagen aus Metall sind relativ dick. Daher können aus einem solchen Laminat (IMS) häufig nur sehr starre Leiterplatten hergestellt werden. Diese bekannten Leiterplatten sind aufgrund ihrer Starrheit nur wenig geeignet, dreidimensional geformt zu werden.

Der Einsatz der bekannten IMS-Leiterplatten erfordert überdies aufwendige Verbindungstechnologien. Eine Verbindung kann beispielsweise über Kabel notwendig sein.

### Darstellung der Erfindung

Der Erfindung liegt daher die Aufgabe zugrunde, eine Leiterplatte der eingangs genannten Art derart auszugestalten und weiter zu bilden, dass diese bei möglichst guter thermischer Leitfähigkeit eine hohe Flexibilität zeigt.

Die vorliegende Erfindung löst die zuvor genannte Aufgabe durch die Merkmale des Patentanspruchs 1.

Erfindungsgemäß ist zunächst erkannt worden, dass ein Dielektrikum mit erhöhter thermischer Leitfähigkeit verwendet werden muss, um zwei sehr dünne, zunächst noch flexible Metalllagen zusammen zu laminieren, um daraus eine sehr flexible Leiterplatte zu fertigen. Weiter ist erkannt worden, dass die Verwendung eines geeigneten Dielektrikums für die Fertigung einer IMS ("insulated metallic substrate") - Leiterplatte notwendig ist. Das erfindungsgemäße Laminat zeigt eine sehr gute thermische Leitfähigkeit, wodurch dieses zur Entwärmung von Schaltungen und LEDs geeignet ist. Erfindungsgemäß ist insbesondere erkannt worden, dass das Laminat sehr dünn ausgestaltet sein muss, um die für eine dreidimensionale Ausgestaltung notwendige Flexibilität aufzuweisen. Das erfindungsgemäße Laminat ist derart flexibel, dass eine mit diesem gefertigte Leiterplatte als dreidimensionale Struktur verbaut werden kann. Trotz einer sehr hohen thermischen Leitfähigkeit der dielektrischen Lage bleiben die Materialien, aus der die Leiterplatte besteht, ausreichend flexibel. So ist eine Leiterplatte, die das erfindungsgemäße Laminat aufweist, als vorgefertigte Schaltung dreidimensional ausgeformt in einer dreidimensional gestalteten Struktur, insbesondere einem Scheinwerfer, verbaubar. Insoweit ist eine Leiterplatte realisierbar, welche bei möglichst guter thermischer Leitfähigkeit eine hohe Flexibilität zeigt.

Folglich ist die eingangs genannte Aufgabe gelöst.

Die zweite Lage könnte als Klebstoff ausgebildet sein, an welcher die erste Lage und die dritte Lage jeweils ausschließlich stoffschlüssig angebunden sind. So kann auf mechanische Anbindemittel verzichtet werden. Die Anbindung kann durch Laminieren erfolgen.

Die erste Lage könnte aus Aluminium und die dritte Lage könnte aus Kupfer gefertigt sein. Aluminium ist ein relativ leichter Werkstoff. In Kupfer können sehr gut leitende Leitungen oder Leitungsbilder eingebracht werden.

Die erste Lage könnte aus Kupfer und die dritte Lage könnte ebenfalls aus Kupfer gefertigt sein. Hierdurch ist eine Materialeinheitlichkeit gegeben, die die Lagerhaltung und Logistik vereinfacht.

Die erste Lage könnte zwischen 25 und 300 µm dick sein. Durch Wahl dieses Dickenbereichs bleibt die Flexibilität des IMS-Materials und damit die Flexibilität der daraus hergestellten Leiterplatte erhalten.

Die zweite Lage könnte zwischen 10 und 70 µm dick sein. Die mechanischen Eigenschaften einer flexiblen Leiterplatte werden mit dem Vorteil einer erhöhten thermischen Leitfähigkeit einer IMS-Schaltung kombiniert.

Vor diesem Hintergrund könnte die dritte Lage könnte zwischen 10 und 70 µm dick sein. Durch Wahl dieses Dickenbereichs bleibt die Flexibilität des IMS-Materials und damit die Flexibilität der daraus hergestellten Leiterplatte erhalten.

Der Klebstoff könnte eine thermische Leitfähigkeit zwischen 0,25 und 3,5 W/mK aufweisen. Eine ein solches Laminat umfassende Leiterplatte kann zur Entwärmung von Hochleistungselektroniken oder von Power-LED-Schaltungen in Scheinwerfern verwendet werden. Die thermische Leitfähigkeit wird nach DIN EN ISO 22007-04:2012 mittels eines Flash-Verfahrens bestimmt.

Die dritte Lage könnte ein Leiterbild tragen. Hierdurch ist eine Leiterplatte als IMS-Leiterplatte ausgestaltet und kann in Scheinwerfern von Fahrzeugen verwendet werden.

Das Leiterbild könnte ätztechnisch hergestellt sein. Durch ein Ätzverfahren können sehr exakte Leiterbilder geschaffen werden.

Konkret kann eine hier beschriebene Leiterplatte im Außenlichtbereich von Fahrzeugen verwendet werden, da sie eine Entwärmung einer Power-LED-Schaltung bewirken kann. Im Außenlichtbereich ist oft eine dreidimensionale Anordnung einer LED gefordert.

### Kurzbeschreibung der Zeichnung

In der Zeichnung zeigen
- Fig. 1: eine ebene Leiterplatte, die aus drei Lagen aufgebaut ist, wobei die drei Lagen ein Laminat bilden,
- Fig. 2: eine weitere ebene Leiterplatte, die aus drei Lagen aufgebaut ist, und
- Fig. 3: die Leiterplatte gemäß Fig. 1, wobei die Leiterplatte dreidimensional verformt ist.

### Ausführung der Erfindung

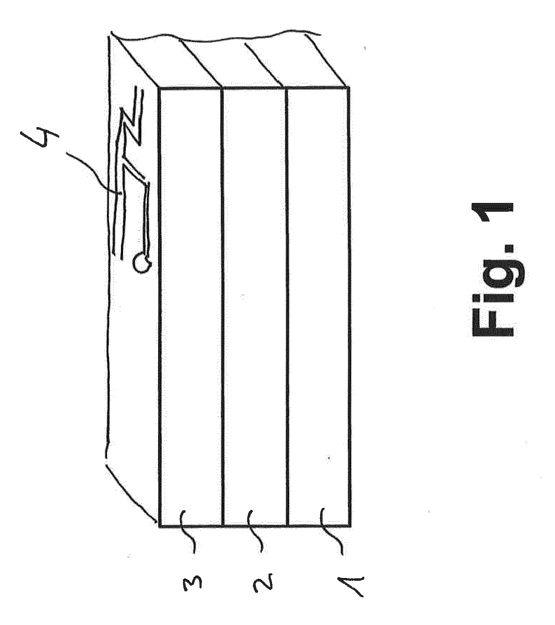

Fig. 1 zeigt eine flexible Leiterplatte zur dreidimensionalen Ausformung, umfassend mindestens drei Lagen 1, 2, 3, wobei eine erste Lage 1 und eine dritte Lage 3 aus Metall gefertigt sind und wobei die erste Lage 1 und die dritte Lage 3 eine zweite Lage 2, welche als dielektrische Lage ausgestaltet ist, zwischen sich aufnehmen. Die zweite Lage 2 ist als Klebstoff ausgebildet, an welcher die erste Lage 1 und die dritte Lage 3 jeweils stoffschlüssig durch Laminieren angebunden sind.

Fig. 1 zeigt daher auch ein flexibles Laminat zur dreidimensionalen Ausformung, umfassend mindestens drei Lagen 1, 2, 3, wobei eine erste Lage 1 und eine dritte Lage 3 aus Metall gefertigt sind, wobei die erste Lage 1 und die dritte Lage 3 eine zweite Lage 2, welche als dielektrische Lage mit einer thermischen Leitfähigkeit ausgestaltet ist, zwischen sich aufnehmen, und wobei die zweite Lage 2 als Klebstoff ausgebildet ist, an welcher die erste Lage 1 und die dritte Lage 3 jeweils stoffschlüssig angebunden sind. Das Laminat weist eine Gesamtdicke zwischen 45 und 440 µm, bevorzugt zwischen 100 µm und 250 µm, auf.

Die zweite Lage 2 ist als Klebstoff ausgebildet, an welcher die erste Lage 1 und die dritte Lage 3 jeweils ausschließlich stoffschlüssig angebunden sind.

Die erste Lage 1 ist aus Aluminium und die dritte Lage 3 ist aus Kupfer gefertigt.

Die erste Lage 1 ist 150 µm dick. Die zweite Lage 2 ist 30 µm dick. Die dritte Lage 3 ist 60 µm dick. Die dritte Lage 3 trägt ein Leiterbild 4. Das Leiterbild 4 ist ätztechnisch hergestellt.

Diese flexible Leiterplatte weist eine Gesamtdicke zwischen 45 und 440 µm, nämlich eine Gesamtdicke von 240 µm auf.

Der Klebstoff weist eine thermische Leitfähigkeit von 1 W/mK auf.

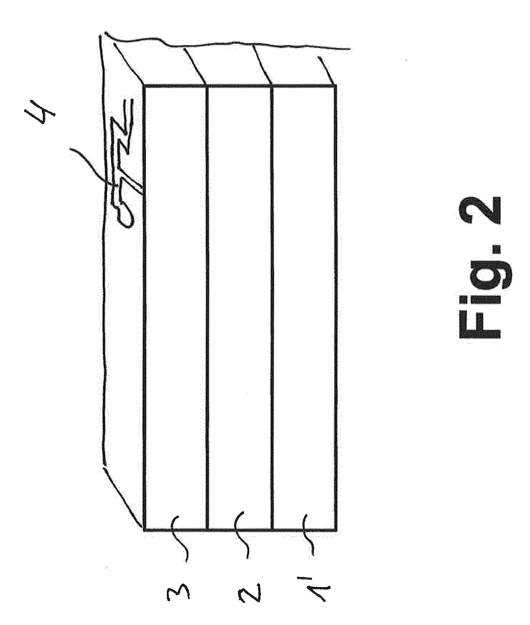

Fig. 2 zeigt eine flexible Leiterplatte zur dreidimensionalen Ausformung, umfassend mindestens drei Lagen 1', 2, 3, wobei eine erste Lage 1' und eine dritte Lage 3 aus Metall gefertigt sind und wobei die erste Lage 1' und die dritte Lage 3 eine zweite Lage 2, welche als dielektrische Lage ausgestaltet ist, zwischen sich aufnehmen. Die zweite Lage 2 ist als Klebstoff ausgebildet, an welcher die erste Lage 1' und die dritte Lage 3 jeweils stoffschlüssig durch Laminieren angebunden sind.

Fig. 2 zeigt auch ein flexibles Laminat zur dreidimensionalen Ausformung, umfassend mindestens drei Lagen 1', 2, 3, wobei eine erste Lage 1' und eine dritte Lage 3 aus Metall gefertigt sind, wobei die erste Lage 1' und die dritte Lage 3 eine zweite Lage 2, welche als dielektrische Lage mit einer thermischen Leitfähigkeit ausgestaltet ist, zwischen sich aufnehmen, und wobei die zweite Lage 2 als Klebstoff ausgebildet ist, an welcher die erste Lage 1' und die dritte Lage 3 jeweils stoffschlüssig angebunden sind. Das Laminat weist eine Gesamtdicke zwischen 45 und 440 µm, bevorzugt zwischen 100 µm und 250 µm, auf.

Die zweite Lage 2 ist als Klebstoff ausgebildet, an welcher die erste Lage 1' und die dritte Lage 3 jeweils ausschließlich stoffschlüssig angebunden sind.

Die erste Lage 1' ist aus Kupfer und die dritte Lage 3 ist auch aus Kupfer gefertigt. Die erste Lage 1' ist 140 µm dick. Die zweite Lage 2 ist 30 µm dick. Die dritte Lage 3 ist 60 µm dick. Die dritte Lage 3 trägt ein Leiterbild 4. Das Leiterbild 4 ist ätztechnisch hergestellt.

Diese Leiterplatte weist eine Gesamtdicke zwischen 45 und 440 µm, nämlich eine Gesamtdicke von 230 µm, auf.

Der Klebstoff weist eine thermische Leitfähigkeit von 1 W/mK auf.

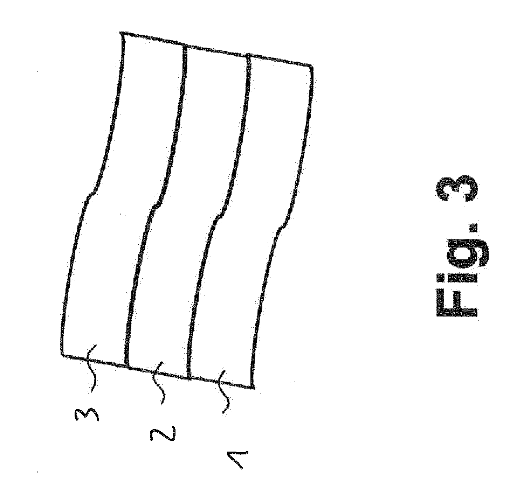

Fig. 3 zeigt die Leiterplatte gemäß Fig. 1, wobei die Leiterplatte dreidimensional verformt ist.

## Patentansprüche

1. Flexibles Laminat zur dreidimensionalen Ausformung, umfassend mindestens drei Lagen (1, 1', 2, 3), wobei eine erste Lage (1, 1') und eine dritte Lage (3) aus Metall gefertigt sind, wobei die erste Lage (1, 1') und die dritte Lage (3) eine zweite Lage (2), welche als dielektrische Lage mit einer thermischen Leitfähigkeit ausgestaltet ist, zwischen sich aufnehmen, und wobei die zweite Lage (2) als Klebstoff ausgebildet ist, an welcher die erste Lage (1, 1') und die dritte Lage (3) jeweils stoffschlüssig angebunden sind,
**dadurch gekennzeichnet, dass** das Laminat eine Gesamtdicke zwischen 45 und 440 µm, bevorzugt zwischen 100 µm und 250 µm, aufweist.

2. Laminat nach Anspruch 1, **dadurch gekennzeichnet, dass** die zweite Lage (2) als Klebstoff ausgebildet ist, an welcher die erste Lage (1, 1') und die dritte Lage (3) jeweils ausschließlich stoffschlüssig angebunden sind.

3. Laminat nach Anspruch 1 oder 2, **dadurch gekennzeichnet, dass** die erste Lage (1) aus Aluminium und die dritte Lage (3) aus Kupfer gefertigt ist.

4. Laminat nach Anspruch 1 oder 2, **dadurch gekennzeichnet, dass** die erste Lage (1') aus Kupfer und die dritte Lage (3) aus Kupfer gefertigt ist.

5. Laminat nach einem der voranstehenden Ansprüche, **dadurch gekennzeichnet, dass** die erste Lage (1, 1') zwischen 25 und 300 µm dick ist.

6. Laminat nach einem der voranstehenden Ansprüche, **dadurch gekennzeichnet, dass** die zweite Lage (2) zwischen 10 und 70 µm dick ist.

7. Laminat nach einem der voranstehenden Ansprüche, **dadurch gekennzeichnet, dass** die dritte Lage (3) zwischen 10 und 70 µm dick ist.

8. Laminat nach einem der voranstehenden Ansprüche, **dadurch gekennzeichnet, dass** der Klebstoff eine thermische Leitfähigkeit zwischen 0,25 und 3,5 W/mK aufweist.

9. Flexible Leiterplatte, umfassend ein Laminat nach einem der voranstehenden Ansprüche, **dadurch gekennzeichnet, dass** die dritte Lage (3) ein Leiterbild (4) trägt.

10. Leiterplatte nach Anspruch 9, **dadurch gekennzeichnet, dass** das Leiterbild (4) ätztechnisch hergestellt ist.
